# FASCICULE DE BREVET EUROPEEN

(11) **EP 3 232 524 B1**
(45) Date de publication et mention de la délivrance du brevet: **06.02.2019**
(21) Numéro de dépôt: 17166646.4
(22) Date de dépôt: 13.04.2017
(51) Int. Cl.: H02B 11/04

(54) **APPAREIL ÉLECTRIQUE DÉBROCHABLE DE COUPURE D'UN COURANT ÉLECTRIQUE PRÉSENTANT UNE PLAQUE DE FOND AMÉLIORÉE**
EINSCHUB-LEISTUNGSSCHALTER MIT EINER VERBESSERTEN RÜCKPLATTE
WITHDRAWABLE CIRCUIT-BREAKER HAVING AN IMPROVED BACKPLATE

(30) Priorité: 15.04.2016 FR 1653362
(43) Date de publication de la demande: 18.10.2017
(73) Titulaire: Schneider Electric Industries SAS, 92500 Rueil-Malmaison (FR)
(72) Inventeur: MARY, Michael, 38050 GRENOBLE CEDEX 09 (FR); PINERO, Eric, 38050 GRENOBLE CEDEX 09 (FR); JACOLIN, Brice, 38050 GRENOBLE CEDEX 09 (FR)
(74) Mandataire: Lavoix

(56) Documents cités:
- WO-A1-01/33682
- DE-A1- 3 328 785
- US-A- 3 170 092
- US-A- 4 205 207

## Description

La présente invention concerne un appareil électrique débrochable de coupure d'un courant électrique présentant une plaque de fond améliorée.

On connaît des appareils électriques de coupure d'un courant électrique, tels que des disjoncteurs ou des interrupteurs, qui comportent un châssis fixe, apte à être monté dans un tableau électrique et une partie amovible, aussi dite « bloc coupure », qui renferme un dispositif électrique de coupure apte à couper un courant électrique. La partie amovible est déplaçable entre des positions embrochée et débrochée par rapport au châssis. Un tel appareil électrique est dit être débrochable.

Dans la position embrochée, la partie amovible est reçue à l'intérieur d'un logement du châssis fixe prévu à cet effet, permettant ainsi de raccorder électriquement le dispositif électrique de coupure à des terminaux de connexion d'une installation électrique raccordés au châssis. Dans la position débrochée, la partie amovible est au moins en partie retirée hors du logement du châssis. Le dispositif électrique de coupure n'est alors plus raccordé à l'installation électrique. Typiquement, l'appareil ne fonctionne que lorsqu'il est dans la position embrochée.

Ces appareils débrochables facilitent les interventions de maintenance et de réparation, car la partie amovible peut être retirée par un opérateur sans avoir besoin de toucher ni de démonter les connexions entre le châssis et l'installation électrique.

Un tel appareil électrique est par exemple connu de WO-01/33682-A1.

Dans cet appareil, la partie amovible comporte une plaque de fond, réalisée en un matériau composite obtenu par pultrusion. Cette plaque de fond a pour rôle d'assurer une bonne tenue mécanique de l'appareil électrique et de résister aux efforts mécaniques statiques et dynamiques subis par l'appareil lorsqu'il est en fonctionnement.

Par exemple, dans la position embrochée, la partie amovible subit des efforts statiques dus au poids des connecteurs électriques, typiquement des jeux de barres électriques en cuivre, qui servent à raccorder l'appareil électrique à l'installation électrique. La partie amovible subit aussi ponctuellement des efforts mécaniques, lors de l'interruption du courant, sous l'effet des forces électromagnétiques apparaissant lors de la coupure d'un courant électrique. Ces forces sont particulièrement importantes dans les appareils à fort pouvoir de coupure, par exemple destinés à couper des courants d'intensité supérieure à 100 kA, où elles peuvent générer des contraintes mécaniques équivalentes à celles exercées par un poids de plusieurs tonnes. Cela fragilise la plaque de fond et peut même la détruire, ce qui nuit au fonctionnement de l'appareil électrique.

Cependant, cette plaque de fond connue de l'état de la technique ne donne pas entière satisfaction. Le procédé de fabrication par pultrusion a comme inconvénient d'être complexe et à mettre en oeuvre et présente des limitations techniques. La plaque de fond ainsi obtenue présente un coût unitaire élevé et une épaisseur importante, ce qui impose un surdimensionnement du châssis fixe et donc une augmentation de l'encombrement de l'appareil électrique.

Les documents suivants sont également connus : US 4 205 207-A, US 3 170 092-A, DE 33 28 785-A1 et WO01/33682-A1.

C'est à ces inconvénients qu'entend plus particulièrement remédier l'invention, en proposant un appareil électrique débrochable de coupure d'un courant électrique, comportant une plaque de fond plus économique à fabriquer et présentant un encombrement réduit, tout en étant apte à supporter les contraintes mécaniques exercées sur l'appareil électrique lors de son fonctionnement.

A cet effet, l'invention concerne un appareil électrique débrochable de coupure d'un courant électrique, comportant :
- un châssis fixe, incluant une plaque de fond rigide fixée sur le châssis ;
- des terminaux de connexion aptes à être raccordés à une installation électrique ;
- une partie amovible incluant un dispositif de coupure d'un courant électrique, cette partie amovible étant sélectivement déplaçable entre :
   - une position embrochée, dans laquelle la partie amovible est reçue à l'intérieur d'un logement correspondant du châssis fixe et dans laquelle le système de coupure est raccordé électriquement aux terminaux de connexion, et
   - une position débrochée, dans laquelle la partie amovible est en dehors du logement et dans laquelle le système de coupure est électriquement isolé des terminaux de connexion.

Selon l'invention, la plaque de fond est réalisée en un matériau polymère thermodurcissable et comporte des poutres de renfort, intégrées à la plaque de fond et s'étendant selon une direction verticale. La plaque de fond est fixée au châssis au moyen d'éléments de fixation, l'appareil électrique comportant en outre des plaquettes de maintien qui s'étendent verticalement le long de bords latéraux de la plaque de fond, les plaquettes de maintien étant serrées contre les bords latéraux par les éléments de fixation.

Grâce à l'invention, la plaque de fond présente une bonne tenue mécanique, du fait notamment des poutres verticales, qui évitent les concentrations de contraintes mécaniques en des endroits localisés de la plaque de fond et au contraire favorisent leur répartition de manière homogène sur la plaque de fond. Celle-ci présente ainsi une résistance mécanique aussi satisfaisante qu'avec les plaques de fond pultrudées connues de l'état de la technique. De plus, la plaque de fond peut être fabriquée de façon simplifiée, par exemple par moulage, ce qui en réduit le coût et permet une plus grande flexibilité dans le dimensionnement, permettant notamment d'en réduire l'encombrement.

Selon des aspects avantageux mais non obligatoires de l'invention, un tel appareil électrique peut incorporer une ou plusieurs des caractéristiques suivantes, prises dans toute combinaison techniquement admissible :
- Les plaquettes de maintien sont réalisées en acier.
- Les éléments de fixation comportent des vis à tête fraisée.
- Les éléments de fixation présentent une surépaisseur inférieure ou égale à 3mm, par rapport à la face de chaque plaquette de maintien tournée vers l'arrière de l'appareil électrique.
- La plaque de fond est formée en une seule pièce.
- La plaque de fond est réalisée en polyester.
- La plaque de fond est réalisée par moulage.
- La superficie de la section transversale de chacune des poutres de renfort est supérieure ou égale à 5cm², de préférence supérieure ou égale à 10cm², de préférence encore supérieure ou égale à 20cm².
- La plaque de fond présente une épaisseur comprise entre 0,5cm et 5cm.

L'invention sera mieux comprise et d'autres avantages de celle-ci apparaîtront plus clairement à la lumière de la description qui va suivre, d'un mode de réalisation d'un appareil électrique donné uniquement à titre d'exemple et faite en référence aux dessins annexés dans lesquels :
- la figure 1 est une illustration schématique, selon une vue en perspective, d'un appareil électrique de coupure d'un courant électrique conforme à l'invention ;
- la figure 2 est une illustration schématique, selon une vue en perspective et partiellement éclatée, de l'appareil électrique de coupure de la figure 1 ;
- la figure 3 est une illustration schématique, en représentation partiellement écorchée, de l'appareil électrique des figures 1 et 2, vu selon le plan de coupe III de la figure 1 ;
- la figure 4 est une vue détaillée de la zone IV de la figure 3.

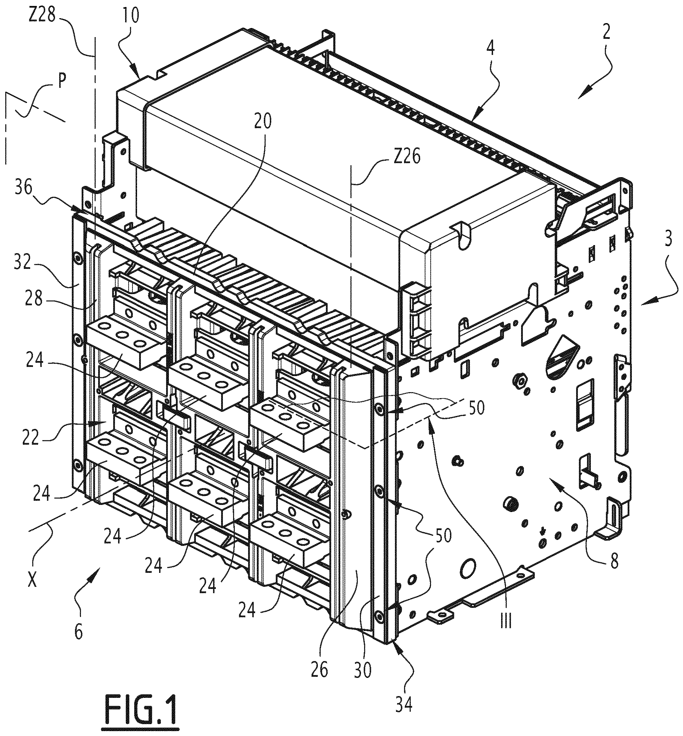

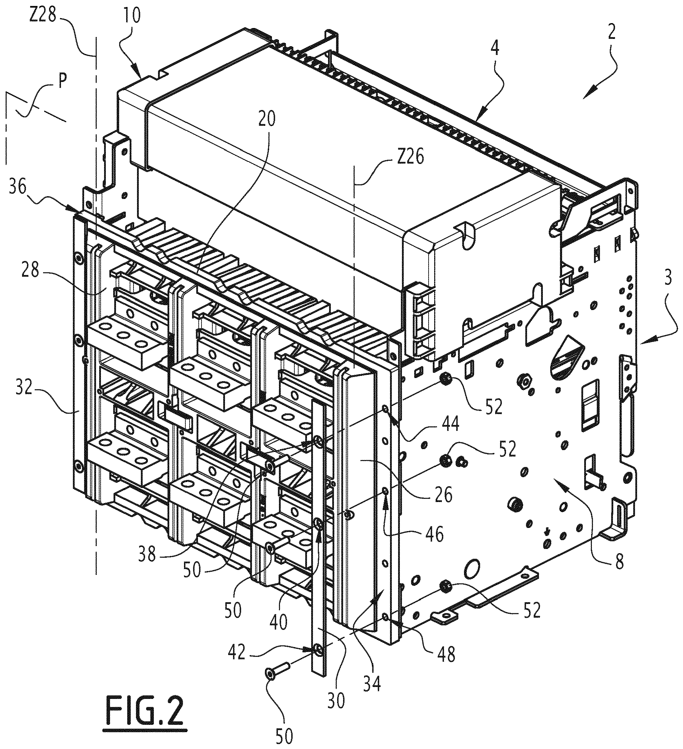

Les figures 1 et 2 représentent un appareil électrique 2 débrochable de coupure d'un courant électrique. L'appareil électrique 2 est configuré pour interrompre un courant électrique, en réponse à une anomalie de fonctionnement ou à une commande prédéfinie. Par exemple, l'appareil électrique 2 est un disjoncteur ou un interrupteur.

Dans cet exemple, l'appareil électrique 2 est un disjoncteur à basse tension à courant alternatif et à coupure dans l'air, par exemple prévu pour une tension électrique supérieure ou égale à 440V et pour des courants électriques d'intensité supérieure à 630 A. Le pouvoir de coupure en court-circuit de ce disjoncteur est de 150kA à 440V. L'appareil électrique 2 est ici multipolaire, c'est-à-dire apte à fonctionner avec une installation électrique polyphasée, par exemple à trois ou à quatre pôles. En variante, le disjoncteur est à courant continu.

L'appareil électrique 2 comporte un châssis 3 fixe et une partie amovible, non illustrée.

Le châssis 3 comporte une face avant 4, une face arrière 6 et des faces latérales 8 et 10. Dans cet exemple, le châssis 3 présente une forme de prisme à base rectangulaire. Les parois latérales 8 et 10 sont ici planes et parallèles l'une avec l'autre. Le châssis 3 définit un logement pour recevoir la partie mobile de l'appareil électrique 2 au moyen d'une ouverture ménagée sur la face avant 4. On note « X » un axe longitudinal de l'appareil électrique 2 qui s'étend horizontalement et parallèlement aux faces latérales 8 et 10 et perpendiculairement aux faces avant 4 et arrière 6.

Dans cette description, la direction verticale est définie par rapport à la direction de la pesanteur terrestre. Les forces dues au poids de différents éléments s'exercent donc sur l'appareil électrique 2 selon cette direction verticale, notamment lorsque l'appareil électrique 2 est dans une configuration montée dans un tableau électrique.

La face arrière 6 comporte une plaque de fond 20, fixée sur le châssis 3, et des terminaux de connexion électriques 24 de l'appareil électrique 2, agencés au niveau de la plaque de fond 20. La plaque de fond 20 est décrite plus en détail dans ce qui suit.

Les terminaux de connexion 24 sont destinés à être raccordés électriquement à une installation électrique, par exemple par l'intermédiaire d'un jeu de barres de connexion électrique dans un tableau électrique. L'installation électrique est par exemple un circuit électrique qu'on souhaite protéger ou commander au moyen de l'appareil électrique 2. Les terminaux de connexion 24 sont réalisés en un matériau électriquement conducteur, tel que du cuivre.

La partie amovible est sélectivement déplaçable entre des positions embrochée et débrochée. Dans la position embrochée, elle est reçue à l'intérieur du logement défini par le châssis 3 et est connectée aux terminaux de connexion 24. Dans la position débrochée, la partie mobile est en dehors du logement défini par le châssis 3. Le dispositif de coupure du courant est déconnecté des terminaux de connexion 24. Le déplacement de la partie amovible entre ses positions embrochée et débrochée est réalisé par translation le long de l'axe X.

La partie amovible peut en outre présenter, bien que ce ne soit pas indispensable, une troisième position, dite position de test, intermédiaire entre les positions embrochée et débrochée. Dans cette position de test, la partie amovible est seulement en partie reçue à l'intérieur du logement délimité par le châssis 3 mais le dispositif de coupure du courant est déconnecté des terminaux de connexion 24.

La partie amovible comporte un dispositif de coupure d'un courant électrique, non illustré, qui est apte et destiné à interrompre sélectivement un courant électrique qui circule entre des terminaux de connexion 24 d'un même pôle lorsque la partie amovible est dans la position embrochée. Des exemples d'une partie amovible de l'appareil électrique 2 sont décrits dans FR 2 783 366 A1 et dans FR 2 777 696 A1.

La plaque de fond 20 a pour fonction de renforcer la tenue mécanique du châssis 3, notamment pour résister aux efforts exercés sur ce dernier au niveau des terminaux de connexion électrique 24. La plaque de fond 20 présente une portion de forme plane qui s'étend selon un plan géométrique P vertical fixe. Ici, le plan P est perpendiculaire à l'axe X et aux parois latérales 8 et 10.

La plaque de fond 20 est rigide et est réalisée en un matériau polymère thermodurcissable, par exemple du polyester. Par « rigide », on entend que le module de Young en flexion de la plaque de fond 20 est supérieur ou égal à 9,5 GPa.

Ici, la plaque de fond 20 est en une seule pièce. De préférence, la plaque de fond 20 est réalisée par moulage. Ainsi, la plaque de fond 20 est facile à fabriquer et présente un coût unitaire réduit tout en ayant de bonnes propriétés de tenue mécanique.

A titre d'exemple illustratif, la plaque de fond 20 présente une épaisseur comprise entre 5 mm et 50 mm, de préférence comprise entre 8 mm et 15 mm. L'épaisseur de la plaque de fond 20 est mesurée parallèlement à l'axe X, au niveau de la portion plane de cette plaque de fond 20, par exemple sur un bord de cette plaque de fond 20. La plaque de fond 20 présente une largeur de 440 mm, mesurée dans le plan P perpendiculairement à l'axe X, et une hauteur de 330 mm, mesurée verticalement dans le plan P.

Ici, la plaque de fond 20 est pourvue, sur une zone centrale, de plusieurs ouvertures traversantes 22, au travers desquelles les terminaux de connexion 24 sortent du châssis 3 à l'arrière de l'appareil électrique 2. Dans cet exemple, les terminaux de connexion 24 sont arrangés par paires. Les terminaux de connexion 24 de chaque paire sont disposés verticalement l'un par rapport à l'autre. Les paires de terminaux de connexion 24 sont alignées horizontalement le long de la face arrière 6. Chaque paire de terminaux de connexion 24 correspond à un pôle électrique du disjoncteur.

La plaque de fond 20 comporte également des poutres de renfort 26 et 28, intégrées à la plaque de fond 20, pour renforcer la tenue mécanique de la plaque de fond 20. Les poutres de renfort 26 et 28 sont intégrés à la plaque de fond 20 en saillie par rapport à la portion plane de la plaque de fond 20, vers l'arrière de la plaque de fond 20. Ces poutres de renfort 26, 28 s'étendent longitudinalement selon des axes verticaux, respectivement notés Z26 et Z28. Les poutres de renfort 26 et 28 sont ici disposées de part et d'autre de la zone centrale de la plaque de fond 20 comportant les ouvertures 22.

Les poutres de renfort 26 et 28 sont ici identiques. Ainsi, dans ce qui suit, seule la poutre de renfort 26 est décrite en détail.

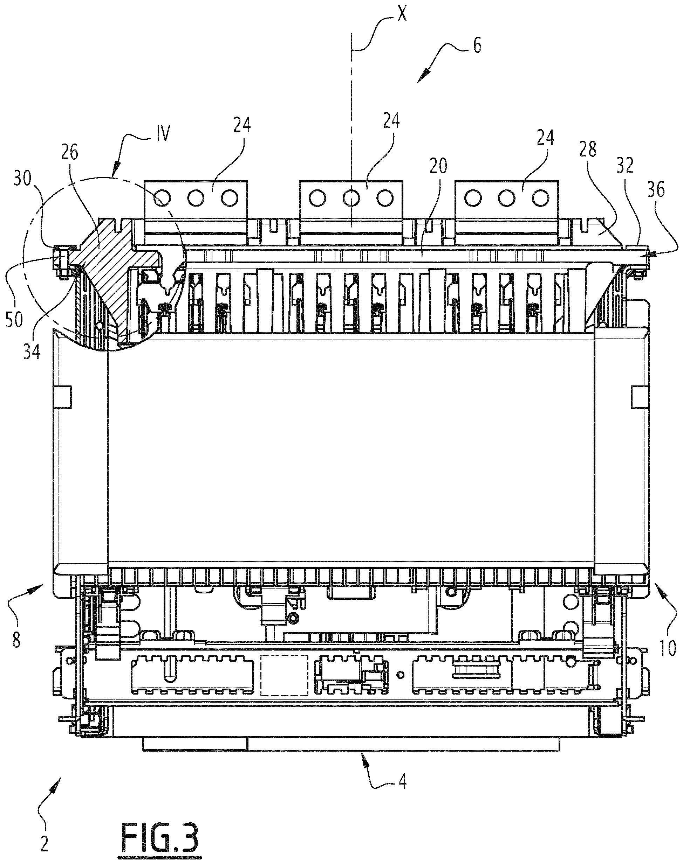

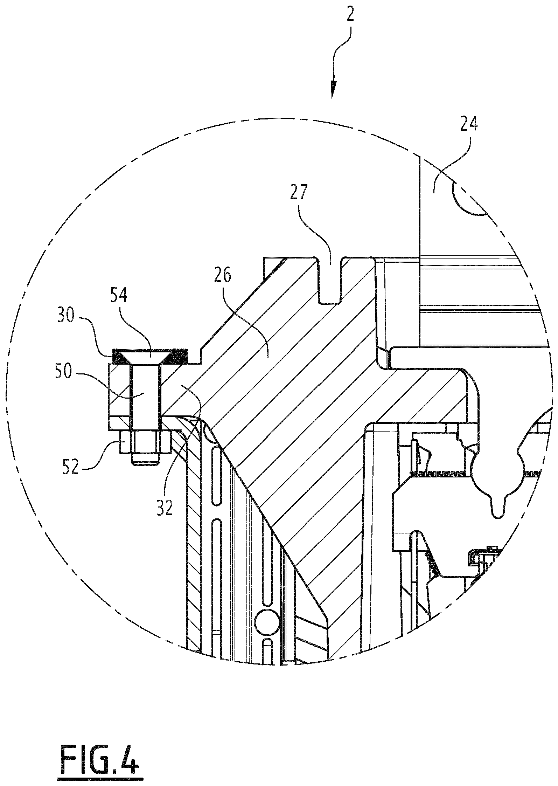

Comme illustré aux figures 3 et 4, la poutre de renfort 26 présente une section transversale supérieure ou égale à 5 cm², de préférence supérieure ou égale à 10 cm², de préférence encore supérieure ou égale à 20cm². Dans cet exemple, cette section transversale présente une forme essentiellement polygonale, par exemple inscrite à l'intérieur d'un trapèze. La section transversale est ici mesurée selon un plan géométrique horizontal perpendiculaire à l'axe Z26.

De préférence, la forme de la poutre de renfort 26 est telle que sa section transversale ne contient pas d'arête vive c'est-à-dire d'arête telle que l'angle entre deux arêtes consécutives, mesurées dans le plan transversal et vers l'intérieur de la poutre de renfort 26, est inférieur ou égal à 60°, de préférence inférieur ou égal à 45°. En effet, de telles arêtes vives favorisent l'apparition de points de rupture mécanique lorsque la poutre de renfort 26 est soumise à un effort mécanique, notamment en compression selon la direction Z26. En l'absence de telles arêtes vives, la fragilité de la poutre de renfort 26 est réduite.

Les poutres de renfort 26 et 28 permettent d'assurer une bonne tenue mécanique à la plaque de fond 20 lorsque l'appareil électrique 2 est monté dans un tableau électrique, aussi bien pour résister à des efforts statiques, par exemple dus au poids des jeux de barres de connexion exercé sur les terminaux de connexion 24, que pour résister à des efforts électrodynamiques qui surviennent lorsque le dispositif de coupure interrompt la circulation d'un courant électrique.

Avantageusement, la poutre de renfort 26 est pourvue d'une rainure 27 qui s'étend le long de la poutre de renfort 26, c'est-à-dire le long de la direction Z26. Cette rainure 27 présente ici une largeur de 5mm, mesurée horizontalement dans le plan P, et une profondeur de 8mm, mesurée parallèlement à l'axe X.

La plaque de fond 20 est fixée au châssis 3, solidairement et sans degré de liberté, au moyen d'éléments de fixation, qui sont décrits plus en détail dans ce qui suit.

L'appareil électrique 2 comporte également des plaquettes de maintien 30, 32 qui sont disposées au niveau de la face arrière de la plaque de fond 20. Plus précisément, les plaquettes de maintien 30, 32 sont chacune disposées sur des bords latéraux 34, 36 de la plaque de fond 20. Ici, la plaquette de maintien 30 est disposée sur un bord latéral 34 de la plaque de fond 20 située du côté de la paroi latérale 8. De façon analogue, la plaquette de fond 32 est disposée sur le bord latéral 36 de la plaque de fond 20 qui se trouve du côté de la paroi latérale 10.

Les plaquettes de maintien 30 et 32 jouent le même rôle vis-à-vis, respectivement, des bords latéraux 34 et 36. Aussi, seule la plaquette de maintien 30 est décrite en détail dans ce qui suit.

La plaquette de maintien 30 présente une forme oblongue s'étendant verticalement parallèlement à l'axe Z26. Ici, la plaquette de maintien 30 présente une forme parallélépipédique rectangle dont la longueur s'étend selon la hauteur de la plaque de fond 20. A titre d'illustration, la plaquette de maintien 30 présente une hauteur de 330 mm, mesurée verticalement dans le plan P et une largeur de 10 mm, mesurée horizontalement dans le plan P.

Dans une configuration montée de l'appareil électrique 2, les plaquettes de maintien 30 et 32 sont serrées en contact contre les bords latéraux 34, 36 respectifs au moyen des éléments de fixation.

Dans cet exemple, la plaque de fond 20 est fixée au châssis 3 par boulonnage. Chaque élément de fixation comporte un boulon formé par une vis 50 et par un écrou 52 correspondant. En variante, les éléments de fixation sont différents, par exemple des rivets.

La plaquette de maintien 30 est pourvue d'une pluralité d'orifices traversants 38, 40, 42. De même, le bord latéral 34 est pourvu d'une pluralité d'orifices traversants 34, 46 et 48. Lorsque la plaquette de maintien 30 est en position montée sur le bord latéral 34, les orifices 38, 40 et 42 sont alignés, respectivement, avec les orifices correspondants 44, 46, 48 du bord latéral 34. De préférence, les orifices 38, 40 et 42 de la plaquette de maintien 30 et les orifices 44, 46, 48 du bord latéral 34 présentent un même diamètre. La paroi latérale 8 présente un bord recourbé pourvu d'orifices qui sont alignés avec les orifices 38, 40 et 42 de la plaque de maintien 30 et avec les orifices 44, 46, 48 du bord latéral 34. Chaque vis 50 est insérée dans un des orifices alignés 38 et 44, 40 et 46 ou 42 et 48 de la plaque de maintien 30 et dans un orifice du bord recourbé de la paroi latérale 8, et est maintenue serrée par un des écrous 52 correspondants, comme illustré aux figures 1 et 2. En variante, le nombre d'orifices ménagés sur la plaquette de maintien 30, sur le bord latéral 34 et sur le bord recourbé de la paroi latérale 8 peut être différent.

En configuration montée de l'appareil, les éléments de fixation, ici les vis 50 et les écrous 52, exercent un pincement par serrage sur la plaquette de maintien 30 et 32 et sur les bords latéraux 34 et 36 de la plaque de fond 20. Ainsi, la plaque de fond 20 est pincée, au niveau de ses bords latéraux 34 et 36, entre les plaquettes de maintien 30 et 32, respectivement, et les bords recourbés correspondants des parois latérales 8 et 10. Par exemple, les vis 50 exercent un effort de serrage supérieur ou égal à 5 N.m.

De cette manière, l'effort de serrage des éléments de fixation, ici des vis 50 et des boulons 52, est réparti sur toute la superficie des bords latéraux 34 et 36. Les plaquettes de maintien 30 et 32 favorisent ainsi une bonne répartition des efforts mécaniques subis par la plaque de fond 20. On évite donc une concentration des contraintes mécaniques en certains points localisés de la plaque de fond 20, ce qui aurait un effet préjudiciable sur la tenue de la plaque de fond 20 et qui favoriserait une rupture mécanique prématurée.

Avantageusement, chacune des vis 50 comporte une tête 54 fraisée. De cette manière, la tête 54 ne dépasse pas de la plaquette de maintien 30 et minimise la surépaisseur lorsque la vis 50 est en configuration montée dans l'appareil 2. Par exemple, l'écart, ou surépaisseur, entre l'extrémité distale de la tête 54 et la face arrière de la plaquette de maintien 30, mesuré parallèlement à l'axe X, est inférieur ou égal à 3 mm, de préférence inférieur ou égal à 1 mm, de préférence encore inférieur ou égal à 0,5mm. La face arrière de la plaquette de maintien 30 est la face qui est tournée vers l'extérieur de l'appareil électrique 2.

Une telle disposition est particulièrement avantageuse. En effet, typiquement, dans des tableaux électriques, il est d'usage d'utiliser les surfaces planes de la face arrière des appareils électriques pour y fixer des cloisons qui s'étendent en saillie à l'arrière des appareils électriques. Dans le cas présent, de telles cloisons sont préférentiellement disposées sur les surfaces planes des bords latéraux 34, 36 de l'appareil 2.

Ces cloisons ont pour fonction de séparer les uns des autres les appareils électriques installés dans un même tableau électrique, afin de protéger des opérateurs contre tout contact accidentel avec un des terminaux électriques sous tension des appareils voisins lorsqu'ils interviennent sur un appareil donné. De telles cloisons servent également à confiner des arcs électriques en cas de défaut électrique et de limiter leur propagation entre des appareils électriques voisins l'un de l'autre au sein du tableau électrique.

Lorsque la tête 54 n'est pas fraisée, elle présente un risque important de dépasser de la plaquette de maintien 30, ce qui introduit une surépaisseur par rapport à la plaquette de maintien 30, et empêche l'installation d'une telle cloison de façon étanche. Il existe alors un interstice important entre la base de la cloison et la plaquette de maintien 30, de sorte qu'un arc électrique peut passer par cet interstice, notamment lors de l'éjection d'un gaz de coupure hors de l'appareil électrique 2. Cela réduit donc l'efficacité et l'utilité d'une telle cloison.

En variante, lorsque l'élément de fixation est un rivet, sa tête sera de préférence agencée là aussi pour éviter toute surépaisseur par rapport à la plaquette de maintien 30, dans le même but.

Dans cet exemple, les plaquettes de maintien 30, 32 sont réalisées en matière métallique, telle que de l'acier. Par exemple, on utilise un feuillard d'un alliage en acier connu sous la référence « DC03 C490 » selon la norme NF EN 10139.

Les modes de réalisation et les variantes envisagés ci-dessus peuvent être combinés entre eux pour générer de nouveaux modes de réalisation dans le cadre des revendications ci-après.

## Revendications

1. Appareil électrique (2) débrochable de coupure d'un courant électrique, comportant :
- un châssis fixe (3), incluant une plaque de fond (20) rigide fixée sur le châssis ;
- des terminaux de connexion (24) aptes à être raccordés à une installation électrique ;
- une partie amovible incluant un dispositif de coupure d'un courant électrique, cette partie amovible étant sélectivement déplaçable entre :
• une position embrochée, dans laquelle la partie amovible est reçue à l'intérieur d'un logement correspondant du châssis (3) fixe et dans laquelle le système de coupure est raccordé électriquement aux terminaux de connexion (24), et
• une position débrochée, dans laquelle la partie amovible est en dehors du logement et dans laquelle le système de coupure est électriquement isolé des terminaux de connexion (24) ;
la plaque de fond (20) étant réalisée en un matériau polymère thermodurcissable et comportant des poutres de renfort (26, 28), intégrées à la plaque de fond (20) et s'étendant selon une direction verticale (Z26, Z28), **caractérisé en ce que** la plaque de fond (20) est fixée au châssis au moyen d'éléments de fixation (50, 52), l'appareil électrique (2) comportant en outre des plaquettes de maintien (30, 32) qui s'étendent verticalement le long de bords latéraux (34, 36) de la plaque de fond (20), les plaquettes de maintien (30, 32) étant serrés contre les bords latéraux (34, 36) par les éléments de fixation (50, 52).

2. Appareil électrique (2) selon la revendication 1, **caractérisé en ce que** les plaquettes de maintien (30, 32) sont réalisées en acier.

3. Appareil électrique (2) selon les revendications 1 ou 2, **caractérisé en ce que** les éléments de fixation (50, 52) comportent des vis (50) à tête fraisée (54).

4. Appareil électrique (2) selon l'une des revendications 1 à 3, **caractérisé en ce que** les éléments de fixation (50, 52) présentent une surépaisseur inférieure ou égale à 3mm, par rapport à la face de chaque plaquette de maintien (30, 32) tournée vers l'arrière de l'appareil électrique (2).

5. Appareil électrique (2) selon l'une des revendications précédentes, **caractérisé en ce que** la plaque de fond (20) est formée en une seule pièce.

6. Appareil électrique (2) selon l'une des revendications précédentes, **caractérisé en ce que** la plaque de fond (20) est réalisée en polyester.

7. Appareil électrique (2) selon l'une des revendications précédentes, **caractérisé en ce que** la plaque de fond (20) est réalisée par moulage.

8. Appareil électrique (2) selon l'une des revendications précédentes, **caractérisé en ce que** la superficie de la section transversale de chacune des poutres de renfort (26, 28) est supérieure ou égale à 5cm², de préférence supérieure ou égale à 10cm², de préférence encore supérieure ou égale à 20cm².

9. Appareil électrique (2) selon l'une des revendications précédentes, **caractérisé en ce que** la plaque de fond (20) présente une épaisseur comprise entre 0,5cm et 5cm.

## Patentansprüche

1. Einschub-Leistungsschalter (2), umfassend:
- einen unbeweglichen Rahmen (3), der eine Rückplatte (20) umfasst, die starr an dem Rahmen befestigt ist;
- Anschlussklemmen (24), die für die Verbindung mit einer elektrischen Installation geeignet sind;
- einen herausnehmbarer Teil, der eine Vorrichtung zum Unterbrechen eines elektrischen Stroms umfasst,
wobei dieser herausnehmbare Teil selektiv bewegbar ist zwischen:
• einer eingefahrenen Position, in welcher der herausnehmbare Teil in dem Inneren einer entsprechenden Aufnahme des unbeweglichen Rahmens (3) aufgenommen ist, und in welcher das Unterbrechungssystem mit den Anschlussklemmen (24) elektrisch verbunden ist, und
• einer ausgefahrenen Position, in welcher der herausnehmbare Teil außerhalb der Aufnahme ist und in welcher das Unterbrechungssystem von den Anschlussklemmen (24) elektrisch getrennt ist;
wobei die Rückplatte (20) aus einem duroplastischen Polymermaterial realisiert ist und Verstärkungsträger (26, 28) aufweist, die in die Rückplatte (20) integriert sind und sich in einer vertikalen Richtung (Z26, Z28) erstrecken, **dadurch gekennzeichnet, dass** die Rückplatte (20) an dem Rahmen mit Hilfe von Befestigungselementen (50, 52) befestigt ist, wobei der Einschub-Leistungsschalter (2) ferner Halteplättchen (30, 32) aufweist, die sich in vertikaler Richtung entlang von seitlichen Rändern (34, 36) der Rückplatte (20) erstrecken, wobei die Halteplättchen (30, 32) durch die Befestigungselemente (50, 52) gegen die seitlichen Ränder (34, 36) geklemmt sind.

2. Einschub-Leistungsschalter (2) nach Anspruch 1, **dadurch gekennzeichnet, dass** die Halteplättchen (30, 32) aus Stahl realisiert sind.

3. Einschub-Leistungsschalter (2) nach Anspruch 1 oder 2, **dadurch gekennzeichnet, dass** die Befestigungselemente (50, 52) Schrauben (50) mit Senkkopf (54) aufweisen.

4. Einschub-Leistungsschalter (2) nach einem der Ansprüche 1 bis 3, **dadurch gekennzeichnet, dass** die Befestigungselemente (50, 52) gegenüber der Fläche jedes Halteplättchens (30, 32), die zu der Rückseite des Einschub-Leistungsschalters (2) gewandt ist, eine Überhöhung aufweisen, die kleiner oder gleich 3 mm ist.

5. Einschub-Leistungsschalter (2) nach einem der vorhergehenden Ansprüche, **dadurch gekennzeichnet, dass** die Rückplatte (20) einstückig ausgebildet ist.

6. Einschub-Leistungsschalter (2) nach einem der vorhergehenden Ansprüche, **dadurch gekennzeichnet, dass** die Rückplatte (20) aus Polyester realisiert ist.

7. Einschub-Leistungsschalter (2) nach einem der vorhergehenden Ansprüche, **dadurch gekennzeichnet, dass** die Rückplatte (20) mittels Gießen realisiert ist.

8. Einschub-Leistungsschalter (2) nach einem der vorhergehenden Ansprüche, **dadurch gekennzeichnet, dass** die Oberfläche des Querschnitts jedes der Verstärkungsträger (26, 28) größer oder gleich 5 cm², bevorzugt größer oder gleich 10 cm², weiter bevorzugt größer oder gleich 20 cm², ist.

9. Einschub-Leistungsschalter (2) nach einem der vorhergehenden Ansprüche, **dadurch gekennzeichnet, dass** die Rückplatte (20) eine Dicke zwischen 0,5 cm und 5 cm aufweist.

## Claims

1. Withdrawable electrical device (2) for cutting off an electric current, comprising:
- a static frame (3), including a rigid back plate (20) fixed on the frame;
- connection terminals (24) capable of being connected to an electrical installation;
- a removable part including an apparatus for cutting off an electrical current, this removable part being selectively movable between:
• an inserted position, in which the removable part is received inside a corresponding housing of the static frame (3) and in which the cut-off system is electrically connected to the connection terminals (24), and
• a withdrawn position, in which the removable part is outside the housing and in which the cut-off system is electrically isolated from the connection terminals (24);
the back plate (20) being made of a thermosetting polymer material and including reinforcing beams (26, 28) integrated in the back plate (20) and extending in a vertical direction (Z26, Z28), **characterized in that** the back plate (20) is fixed to the frame by means of fixing elements (50, 52), the electrical device (2) also comprising retaining strips (30, 32) which extend vertically along lateral edges (34, 36) of the back plate (20), the retaining strips (30, 32) being clamped against the lateral edges (34, 36) by the fixing elements (50, 52).

2. Electrical device (2) according to claim 1, **characterized in that** the retaining strips (30, 32) are made of steel.

3. Electrical device (2) according to claims 1 or 2, **characterized in that** the fixing elements (50, 52) comprise screws (50) with a countersunk head (54).

4. Electrical device (2) according to one of claims 1 to 3, **characterized in that** the fixing elements (50, 52) have a raised portion of less than or equal to 3 mm with respect to the face of each retaining strip (30, 32) facing the rear of the electrical device (2).

5. Electrical device (2) according to one of the preceding claims, **characterized in that** the back plate (20) is formed in one single piece.

6. Electrical device (2) according to one of the preceding claims, **characterized in that** the back plate (20) is made of polyester.

7. Electrical device (2) according to one of the preceding claims, **characterized in that** the back plate (20) is produced by moulding.

8. Electrical device (2) according to one of the preceding claims, **characterized in that** the surface area of the cross-section of each of the reinforcing beams (26, 28) is greater than or equal to 5 cm², preferably greater than or equal to 10 cm², more preferably greater than or equal to 20 cm².

9. Electrical device (2) according to one of the preceding claims, **characterized in that** the back plate (20) has a thickness between 0.5 cm and 5 cm.
